# FASCICULE DE BREVET EUROPEEN

(11) **EP 3 101 699 B1**
(45) Date de publication et mention de la délivrance du brevet: **13.12.2017**
(21) Numéro de dépôt: 16170679.1
(22) Date de dépôt: 20.05.2016
(51) Int. Cl.: H01L 33/58, G02B 6/43, H01S 5/022, H01L 31/0203, G02B 7/02, H04B 10/80, H01L 33/48, G02B 6/42, H01L 25/075, G01J 1/44, H01S 5/183, H05K 1/02, H05K 3/30, G01J 1/04, H01L 31/0232, H05K 5/00, H05K 1/18

(54) **MODULE OPTOELECTRONIQUE POUR LIAISON OPTIQUE SANS CONTACT, MODULES MULTIVOIES ASSOCIES, SYSTEME D'INTERCONNEXION, PROCEDE DE REALISATION ET DE CONNEXION A UNE CARTE ASSOCIES**
OPTOELEKTRONISCHES MODUL FÜR DIE KONTAKTLOSE OPTISCHE VERBINDUNG, ENTSPRECHENDE MEHRKANALMODULE, VERNETZUNGSSYSTEM, ENTSPRECHENDES UMSETZUNGS- UND VERBINDUNGSVERFAHREN MIT EINER KARTE
OPTOELECTRONIC MODULE FOR CONTACTLESS OPTICAL LINK, RELATED MULTI-CHANNEL MODULES, INTERCONNECTION SYSTEM, AND ASSOCIATED METHOD FOR MANUFACTURING AND CONNECTING TO A CARD

(30) Priorité: 02.06.2015 FR 1554994
(43) Date de publication de la demande: 07.12.2016
(73) Titulaire: RADIALL, 93300 Aubervilliers (FR)
(72) Inventeur: FOUCAL, Vincent, 69008 LYON (FR); CLAUDEPIERRE, Chrisitan, 69800 SAINT PRIEST (FR); PEZ, Mathias, 75008 PARIS (FR); PUJOL, Laurence, 38920 CROLLES (FR); QUENTEL, François, 38150 VILLE SOUS ANJOU (FR)
(74) Mandataire: Nony

(56) Documents cités:
- EP-A2- 0 585 186
- WO-A2-2004/049022
- JP-A- S5 925 284
- US-A- 4 727 457
- US-A- 5 266 794
- US-A- 5 783 815
- US-A1- 2004 080 658
- US-A1- 2004 184 737
- US-A1- 2011 058 817
- US-B1- 6 393 183

## Description

### Domaine de l'invention

La présente invention concerne un module optoélectronique pour liaison optique en espace libre sans contact, destiné généralement à être brasé sur une carte électronique aussi appelée circuit imprimé d'acronyme anglais PCB pour « *Printed Circuit Board"* et dite carte d'application, et destiné à convertir des signaux électriques en des signaux optiques ou vice-versa.

Elle concerne aussi bien un module émetteur qu'un module récepteur et un système d'interconnexion comprenant au moins un dispositif avec module émetteur et au moins un dispositif avec module récepteur adapté pour le couplage optique avec le module émetteur, destiné à réaliser la conversion d'un signal électrique en un signal optique par le module émetteur et une conversion du signal optique émis par le module émetteur et reçu par le module récepteur en un signal électrique par ce dernier.

L'application principale visée par l'invention est la liaison entre deux cartes électroniques usuellement appelée connexion carte-à carte ou encore « Board-to-Board » en anglais.

Plus généralement l'invention peut concerner toute liaison entre deux équipements adjacents, avec le cas échéant l'un et/ou l'autre en déplacement relatif l'un par rapport à l'autre.

L'invention vise en premier lieu à améliorer la compacité des modules optoélectronique fixés sur une carte électronique, en, particulier pour réduire la surface d'emprise sur celle-ci.

L'invention concerne de façon générale les systèmes d'interconnexion optiques destinés à être mis en oeuvre notamment dans le domaine médical, le domaine aéronautique ou du transport, le domaine spatial ou encore le domaine des télécommunications, le domaine des communications de données et le domaine de l'industriel, c'est-à-dire des applications dites « Market To Market ».

### Etat de l'art

Pour réaliser des systèmes d'interconnexion entre deux cartes électroniques d'application, ou autrement dit d'utilisation finale, plusieurs types de liaisons sont connues.

On peut citer tout d'abord les liaisons électriques entre cartes qui présentent un certain nombre d'inconvénients majeurs pour des systèmes à très hauts débits. Tout d'abord, lorsqu'elles présentent une densité importante de voies, des interférences électromagnétiques entre voies sont générées, qui sont nuisibles à la qualité des signaux plus la fréquence du signal augmente. Ensuite, les liaisons électriques en tant que connexions dites de fonds de paniers («backplane» en anglais), qui sont utiles dans le domaine des télécommunications et des industries de traitement de données, ne peuvent pas mettre en oeuvre facilement des signaux électriques très haut débit sur des dimensions compatibles avec la distance maximale inter-carte (sur le fond de panier) du fait des problématiques d'atténuation et d'adaptation d'impédance.

On connaît également des systèmes de liaison optique avec contact, qui utilisent des modules optoélectroniques et un lien optique réalisé par une ou plusieurs fibres optiques. Chaque module optoélectronique émetteur ou récepteur usuellement désigné sous l'acronyme anglais OSA pour « Optical Subassembly » est constitué d'une carte électronique, d'un composant optoélectronique et de son composant électronique de commande, d'une ou plusieurs fibres optiques qui peuvent être concaténées en rubans et d'un dispositif de couplage optique entre le composant optoélectronique et la ou les fibres optiques. Chaque module OSA est ensuite fixé, de préférence par brasage sur une carte d'application, un système de liaison optique fonctionnel comprenant ainsi au moins un module émetteur (TOSA pour « Transmitter Optical Subassembly ») et au moins un module récepteur (ROSA pour « Receiver Optical Subassembly ») couplé optiquement au module émetteur TOSA.

On peut citer les produits commerciaux dénommés D-Lightsys® commercialisés par le déposant RADIALL qui peuvent concerner aussi bien un module ROSA qu'un module TOSA, ou un système intégrant les deux modules ROSA et TOSA.

Si ces systèmes de liaison optique ont donné et donnent encore entière satisfaction en particulier en termes de performances, notamment pour des signaux à haut débit, ils peuvent encore être améliorés notamment en termes de poids, d'encombrement, et de coûts de réalisation des modules.

Les besoins liés à certaines applications embarquées, impliquent que l'encombrement maximal qu'un module optoélectronique, que ce soit l'émetteur ou le récepteur, peut occuper sur chaque carte d'application soit très réduit. Ainsi, l'emprise surfacique possible sur une carte d'application d'un module doit être inférieure à 100 mm² pour certaines applications aéronautiques.

Or, tous les modules optoélectroniques à fibres optiques connus, tels que ceux présents dans la gamme D-Lightsys®, présentent une emprise surfacique bien supérieure du fait, soit de la mise en oeuvre de la connectique nécessaire pour s'interfacer avec la fibre optique, soit de la mise en oeuvre de la fibre optique directement au sein du TOSA ou du ROSA.

En plus, de la contrainte d'emprise surfacique moindre, il existe d'autres besoins à prendre en compte :
- assurer une conversion électro-optique (émetteur) et optoélectronique (récepteur) de signaux numériques ou analogiques dans une bande de 0 à plusieurs dizaines de gigabits par seconde (Gbps) ou Gigahertz,
- permettre de faire transiter le signal optique d'une carte à l'autre malgré un alignement émetteur/récepteur imparfait (décalage latéral et angulaire) et d'assurer la continuité du lien dans ces conditions,
- définir une liaison robuste, c'est-à-dire compatible avec des environnements des environnements fortement contraints, tels que l'aérospatial, l'aéronautique, le médical, les télécoms et celui de la défense, et notamment être capables de fonctionner à des températures de -40°C à +85°C, et de résister à des chocs et vibrations selon les normes aéronautiques en vigueur,
- avoir une très faible consommation électrique, typiquement inférieure à 150 mW.

Par ailleurs, il peut également y avoir un intérêt à trouver des techniques alternatives dans le cas où les nouveaux liens à haut débit doivent s'intégrer à un système dont plusieurs éléments restent figés, comme un fond de panier par exemple.

Il existe donc un besoin particulier pour améliorer les liaisons optiques en espace libre sans contact mécanique à modules optoélectroniques, en vue de réduire l'emprise surfacique de ces derniers sur les cartes électroniques sur lesquelles ils sont destinés à être fixés.

De manière plus générale, il existe un besoin pour améliorer les liaisons optiques en espace libre sans contact à modules optoélectroniques qui répondent au besoin particulier, notamment en vue de permettre une distance carte à carte faible voire très faible, d'assurer une conversion électro-optique et une conversion optoélectronique de signaux à cadence élevée, de permettre la transmission effective des signaux malgré un alignement entre module émetteur et module récepteur imparfait, d'être compatible avec des environnements aéronautiques, et d'avoir une consommation électrique réduite.

Le but de l'invention est de répondre au moins en partie à ce(s) besoin(s).

### Exposé de l'invention

Pour ce faire, l'invention a pour objet, un module optoélectronique, destiné à assurer une conversion d'un signal électrique depuis une carte électronique en un signal optique propagé en espace libre ou vice-versa, comprenant l'empilement suivant :
- une carte électronique, destinée à servir d'interface avec une carte électronique d'application ;
- un composant électronique de commande adapté pour réaliser la commande d'un composant optoélectronique, le composant électronique étant fixé directement sur la carte électronique et relié électriquement au circuit électronique;
- un composant optoélectronique adapté pour émettre ou recevoir un signal lumineux par sa surface supérieure, le composant optoélectronique étant fixé directement sur le dessus du composant électronique de commande et relié électriquement au composant électronique ;
- un dispositif optique adapté pour transmettre un signal optique ;
- un support de dispositif optique, le support étant fixé, de préférence par collage ou brasage, directement sur la carte électronique de sorte à assurer l'alignement mécanique entre le dispositif optique et le composant optoélectronique.

On précise que dans le cadre de l'invention, la carte électronique du module optoélectronique est un circuit imprimé ou un empilement de feuilles de matériaux diélectriques, tels que l'alumine, dans lequel un circuit électrique est réalisé.

La carte électronique du module est nécessairement indépendante de la carte électronique d'application ou d'utilisation finale sur laquelle le module selon l'invention est destiné à être fixé. La fixation d'un module optoélectronique selon l'invention sur une carte d'application peut être réalisée par les interconnexions électriques de cette dernière.

On peut en variante remplacer les interconnexions électriques sur la carte d'application par une connexion démontable à l'aide de connecteurs électriques sur le module et sur la carte d'application pour un module démontable / remontable.

Par « composant optoélectronique » et « composant électronique de commande », on entend ici et dans le cadre de l'invention, des composants nus, c'est-à-dire qui ne sont pas enveloppés d'un emballage ou autrement dit encapsulés dans un enrobage isolant électrique, aussi appelé couramment «packaging » en anglais.

Le module selon l'invention peut constituer un module émetteur, le composant électronique de commande étant un circuit de commande de composants optoélectroniques émettant par la surface. Il peut s'agir d'un circuit de commande d'une diode laser à cavité verticale émettant par la surface, de type VCSEL ou une diode électroluminescente LED ou tout autre composant photoémetteur vertical.

Le module optoélectronique selon l'invention peut également constituer un module récepteur, le composant électronique de commande étant un amplificateur à transimpédance, le composant optoélectronique étant une photodiode, notamment une photodiode PIN.

Le module selon l'invention est avantageusement agencé à une distance comprise entre distance entre 1 et 400 mm de son module complémentaire.

Le composant électronique de commande peut être collé ou brasé ou fixé selon une technique dite « puce retournée » (« flip-chip » en anglais) directement sur la surface de la carte électronique.

De même, le composant optoélectronique peut être collé, brasé ou fixé selon une technique dite « puce retournée » (« flip-chip » en anglais) directement sur la surface du composant électronique de commande.

Le dispositif optique peut être une lentille. Cette lentille peut être une lentille réfractive ou une lentille diffractive ou une combinaison d'éléments réfractifs et diffractifs. Ce dispositif peut aussi intégrer un élément diffusant tel qu'un diffuseur holographique par exemple. Selon une variante de réalisation avantageuse, le module selon l'invention comprend un capot fixé directement sur la carte électronique, le capot étant adapté pour protéger mécaniquement les composants et la carte électronique et le cas échéant la lentille et son support vis-à-vis de l'environnement extérieur. De préférence, le capot est adapté pour maintenir la lentille dans son support.

Selon une variante en lieu et place de la lentille, on peut utiliser une fenêtre transparente à au moins une longueur d'onde d'émission ou de réception du composant optoélectronique. Il peut s'agir d'une lame plane agencée directement au-dessus de l'empilement du module, c'est-à-dire directement au-dessus du composant optoélectronique. Selon cette variante, le capot peut comprendre, sur sa face supérieure, une fenêtre transparente à au moins une longueur d'onde d'émission ou de réception du composant optoélectronique, la fenêtre transparente étant scellée de manière hermétique au corps du capot.

Quel que soit le dispositif optique agencé au-dessus d'un module selon l'invention, on peut avantageusement déterminer ses caractéristiques de divergence ou de convergence en fonction de la distance entre un module émetteur et un module récepteur, de sorte que le rapport entre l'intensité lumineuse émise par le module émetteur et l'intensité captée par le module récepteur varie entre 5 et 25 dB environ.

Le substrat de la carte électronique peut comprendre sur sa face supérieure, une ou plusieurs des caractéristiques suivantes en combinaison :
- au moins un premier groupe de repères formant des mires de positionnement du composant optoélectronique relativement à la carte électronique ;
- au moins un deuxième groupe de repères formant des mires de positionnement du composant optoélectronique relativement au support de lentille ;
- au moins un troisième groupe de repères formant des mires de positionnement du module optoélectronique relativement à une carte électronique d'application sur laquelle le module est destiné à être fixé. Ce troisième groupe de mires peut également être sur la face inférieure ou sur l'un au moins de faces latérales du substrat de la carte électronique.

Les trois groupes de repères sont avantageusement regroupés en un seul dans l'invention proposée afin d'optimiser les alignements relatifs.

Des techniques classiques d'auto-alignement dans les composants montés en surface (CMS) telles que la refusion (QFN pour « Quad Flat Non leads package » en anglais) peuvent permettre de s'affranchir de ce troisième groupe de repères.

Avantageusement, chaque mire est constituée d'un quadrillage de carrés adjacents, deux carrés adjacents présentant un contraste entre eux.

Le substrat de la carte électronique peut comprendre un connecteur électrique destiné à être connecté avec un connecteur électrique complémentaire relié à la carte électronique d'application.

L'invention concerne sous un autre aspect un module multivoies comprenant au moins deux modules optoélectroniques décrits ci-dessus avec une carte électronique commune sur laquelle les composants électroniques de commande sont fixés.

Le module multivoies peut comprendre un dispositif optique et un support de dispositif optique communs aux modules optoélectroniques.

Un des deux modules optoélectroniques peut être un module émetteur et l'autre des deux modules un module récepteur.

Les modules optoélectroniques d'un même module multivoies peuvent être tous du même type, émetteur ou récepteur. Dans ce cas, avantageusement, les composants optoélectroniques sont tous réalisés dans une même puce appelée généralement barrette. De la même façon, les composants électroniques de commande des modules optoélectroniques peuvent être associés en barrette.

Le module multivoies peut comprendre au moins deux modules émetteurs tels que des diodes lasers qui peuvent fonctionner à des longueurs d'onde différentes. Cela permet de différentier plus facilement les canaux optiques.

L'invention concerne également un système d'interconnexion optique comprenant :
- au moins un module émetteur décrit précédemment ;
- au moins un module récepteur décrit précédemment.

Avantageusement, la distance entre module émetteur et module récepteur est comprise entre 1 et 400 mm.

L'invention concerne également sous encore un autre de ses aspects un procédé de réalisation d'un module optoélectronique décrit précédemment, comprenant les étapes suivantes:
- positionnement mécanique du composant électronique de commande par rapport à la carte électronique puis fixation du composant de commande directement sur la carte;
- alignement mécanique du composant optoélectronique par rapport à la carte électronique au moyen du premier groupe de mires, puis fixation du composant optoélectronique aligné, directement sur le composant de commande fixé ;
- alignement mécanique du support de dispositif optique par rapport au composant optoélectronique au moyen du deuxième groupe de mires, puis fixation du support de dispositif optique aligné, directement sur la carte.

L'invention concerne enfin un procédé de connexion d'un module optoélectronique décrit précédemment sur une carte électronique d'application, comprenant une étape d'alignement mécanique du module optoélectronique par rapport à la carte électronique d'application au moyen du troisième groupe de mires, puis fixation du module optoélectronique aligné, directement sur la carte électronique d'application, de préférence par soudure de refusion selon une technique dite de composant monté en surface (CMS).

Grâce à l'empilement de composants nus sur une carte électronique, l'emprise surfacique d'un module optoélectronique selon l'invention est bien moindre qu'un module selon l'état de l'art.

Avec les dimensions usuelles des composants optoélectroniques et des composants électroniques de commande, la surface d'emprise d'un module selon l'invention sur une carte d'application peut être inférieure à 100 mm², typiquement de l'ordre de 64 mm².

Un avantage subséquent à l'empilement direct est que le composant optoélectronique, en particulier un laser VCSEL peut être maintenu dans un environnement thermique favorable à basse température par le composant de commande en dessous, en particulier par le pilote du laser. La puce électronique inférieure joue le rôle de drain thermique.

Des modules optoélectroniques émetteur et récepteur selon l'invention peuvent être utilisés pour réaliser une liaison optique carte-à-carte avec une distance faible voire très faible, typiquement inférieure à la dizaine de mm, puisque, l'émission et la réception des signaux optiques par la surface active d'un laser VCSEL respectivement d'une photodiode PIN, est très efficace sans perte même à un débit élevé.

Et pour cette même raison, des modules optoélectroniques émetteur et récepteur selon l'invention peuvent aussi être utilisés pour réaliser une liaison optique carte-à-carte avec une distance élevée, typiquement de quelques dizaines de mm.

Les groupes de mires en tant que repères visuels permettent de réaliser de manière simple un alignement mécanique très précis entre composants d'un module selon l'invention et de celui-ci avec la carte d'application sur laquelle il est fixé, et ce au moyen d'une machine de positionnement des composants usuelle, couramment désignée sous l'expression « pick and place ».

Avec un module émetteur et un module récepteur selon l'invention, les inventeurs pensent qu'on peut obtenir une liaison optique pour une gamme large d'application car il est possible de faire varier les paramètres de :
- distance entre module émetteur et module récepteur entre 1 et 400 mm,
- cadence des signaux numériques transmis entre 0 et plusieurs dizaines de Gbps,
- tolérances de désalignement axial de 0 à 10 mm, et angulaire de 0 à 10°.

Typiquement avec une surface d'emprise sur une carte de l'ordre de 64 mm² pouvant être réduite jusqu'à 16 mm², un module selon l'invention peut présenter un débit maximal de signaux numériques de 10 Gbps ou plus pour une distance carte à carte de 50 mm.

Les avantages d'un module optoélectronique selon l'invention comparativement à un module optoélectronique à fibre(s) optique(s) selon l'état de l'art sont ainsi nombreux parmi lesquels on peut citer :
- réduction de la taille du module, et en particulier de la surface d'emprise sur une carte d'application, ce qui permet de répondre à des applications de connexion carte-à-carte à distance faible voire très faible, typiquement de 1 à quelques dizaines de mm ;
- réduction du poids du fait de la suppression d'éléments notamment du dispositif de couplage optique entre composant optoélectronique et fibre(s) optique(s) ;
- optimisation du coût car des fibres optiques peuvent représenter un coût significatif du prix d'un module optoélectronique ;
- facilité de reconfigurer un système à modules émetteur et récepteur selon l'invention et de déconnecter une carte électronique d'un fond de panier : en effet, avec un module selon l'invention, une carte peut être remplacée par une autre dans un fond de panier sans difficultés liées à la présence de fibres optiques, et/ou de répondre à des besoins d'alignements très précis ;
- possibilité d'établir une communication par liaison optique entre deux éléments nécessitant une déconnexion très rapide si besoin ;
- facilité d'installation sur carte avec les équipements de reports électroniques standards car il n'y a pas de mise en place de fibres optiques à gérer et les précisions d'alignement sont compatibles avec les précisions de positionnement des cartes d'application.

### Description détaillée

D'autres avantages et caractéristiques de l'invention ressortiront mieux à la lecture de la description détaillée d'exemples de mise en oeuvre de l'invention faite à titre illustratif et non limitatif en référence aux figures suivantes parmi lesquelles :
- la figure 1 est une vue schématique de côté d'un exemple de réalisation d'un module optoélectronique selon l'invention,
- la figure 2 est une vue en perspective d'un exemple de module optoélectronique selon une variante de l'invention,
- la figure 2A est une vue en coupe du module selon la figure 2 dans la version émetteur,
- la figure 3 est une vue en éclaté des principaux composants du module émetteur selon la figure 2A,
- la figure 4 est une vue en perspective d'un exemple de module optoélectronique dans la version récepteur selon une variante de l'invention,
- la figure 5 est une vue de dessus d'une carte électronique d'un module selon l'invention, la figure montrant un premier groupe de mire permettant l'alignement mécanique entre la carte et le composant optoélectronique ;
- la figure 6 est une vue de dessus d'une carte électronique d'un module selon l'invention, la figure montrant un deuxième groupe de mire permettant l'alignement mécanique entre le composant optoélectronique et le support de la lentille optique,
- la figure 7 est une vue de dessus d'une carte électronique d'un module selon l'invention, la figure montrant un troisième groupe de mire permettant l'alignement mécanique entre le module optoélectronique et la carte d'application sur laquelle il est destiné à être fixé,
- les figures 8A à 8D montrent schématiquement différentes configurations de systèmes d'interconnexions optiques avec au moins un module optoélectronique émetteur et un module récepteur selon l'invention, certains systèmes étant constitués de modules multivoies.

Dans l'ensemble de la demande, les termes « vertical », « inférieur », « supérieur », « bas », « haut », « dessous », « dessus » sont à comprendre par référence par rapport au sens de l'empilement des différents composants d'un module optoélectronique selon l'invention.

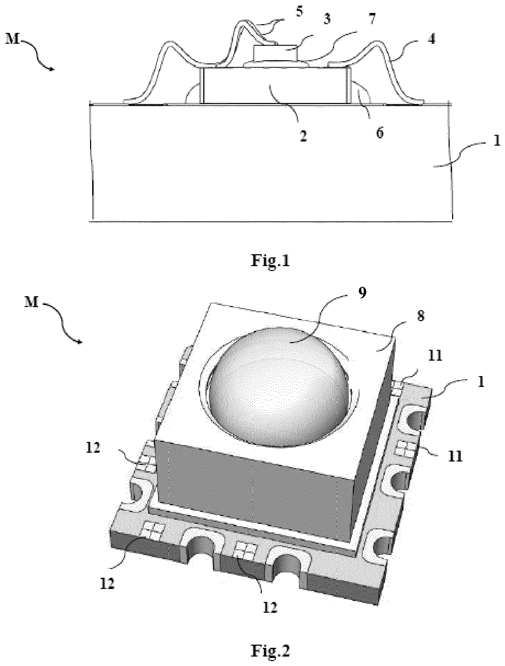

On a représenté en figure 1 un module optoélectronique M selon l'invention.

Les différents éléments du module M sont empilés les uns sur les autres et fixés entre eux, de préférence par collage au moyen d'une colle époxy par exemple ou par brasage.

Ainsi, de bas en haut de l'empilement, le module M comprend :
- un circuit imprimé 1 qui va servir d'interface avec une carte électronique d'application ;
- un composant électronique de commande 2 fixé directement sur le circuit imprimé 1 et relié électriquement au circuit électronique par fils soudés 4 selon une technique de « wire-bonding » ou pontage;
- un composant optoélectronique 3 adapté pour émettre ou recevoir un signal lumineux par sa surface supérieure, le composant optoélectronique étant fixé directement sur le dessus du composant électronique de commande et relié électriquement au composant électronique par une technique de micro-câblage filaire, par exemple au moyen des fils soudés 5, ou par une technique d'assemblage « flip-chip » ou autres techniques d'interconnexion électronique de la micro-électronique classique.

Les composants 2 et 3 sont des composants nus, c'est-à-dire non encapsulés.

En lieu et place d'un circuit imprimé (PCB pour « Printed Circuit Board »), on peut aussi avoir une carte électronique dont le substrat est constitué d'un empilement de couches ou feuilles de matériaux diélectriques, tels que l'alumine et au sein duquel un circuit de conducteurs électriques est agencé.

Comme illustré en figure 1, la fixation respectivement du composant électronique de commande 2 sur le circuit 1 et du composant optoélectronique sur le composant de commande 2 peut être effectué au moyen d'une colle en résine époxy par exemple ou une brasure 6 respectivement 7. En variante, la technique d'assemblage « flip-chip » peut être également utilisée. Cette technique permet d'assurer simultanément la fonction de fixation mécanique et de connexion électrique. D'autres techniques classiques telles que celle du câblage collectif, câblage 3D, etc.... peuvent aussi être utilisées.

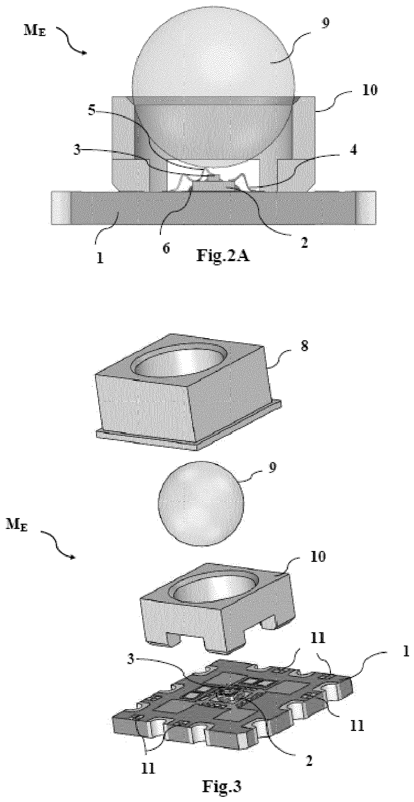

Le module optoélectronique selon l'invention peut être un module émetteur comme illustré aux figures 2, 2A et 3, auquel cas le composant optoélectronique 3 est un laser à cavité verticale émettant par la surface (VCSEL pour « Vertical-Cavity Surface-Emitting Laser) ou tout autre composant optoélectronique émettant par la surface et le composant électronique 2 est une unité de pilotage de laser (« driver » en anglais).

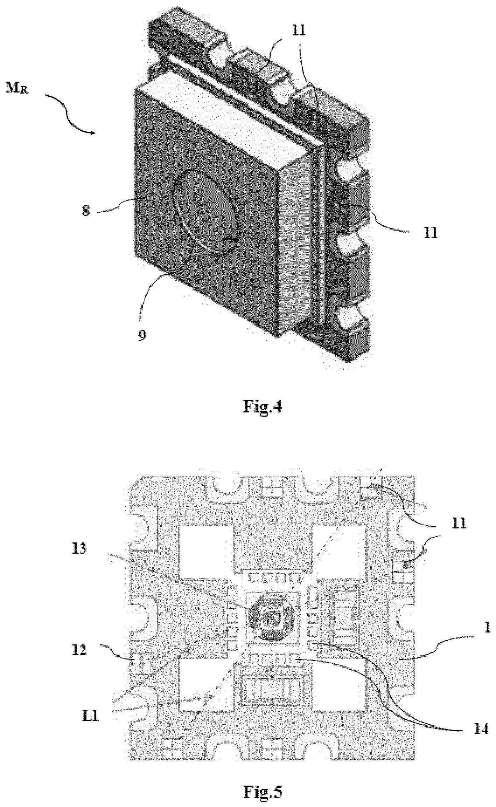

Le module optoélectronique selon l'invention peut être un module récepteur comme illustré en figure 4, auquel cas le composant optoélectronique 3 est une photodiode de type PIN et le composant électronique 2 est un amplificateur à transimpédance pour photodiode.

L'empilement montré en figure 1 permet au module optoélectronique selon l'invention d'avoir une faible surface d'emprise sur une carte d'application.

Avantageusement, le module selon l'invention comprend un capot 8 pour protéger mécaniquement les composants 2, 3, 4, 5, 6, 7, 9 de l'empilement et le circuit imprimé 1.

Selon l'invention, comme illustré aux figures 2 à 4, le module M comprend une lentille 9 montée dans un support 10 directement fixé, de préférence par brasage ou collage au circuit imprimé 1. Le support 10 de la lentille 9 est dimensionné et fixé de sorte à assurer l'alignement mécanique entre la lentille 9 et le composant optoélectronique 3. Ainsi le dispositif optique n'est pas en contact direct avec la surface active du composant optoélectronique et ne risque pas de l'endommager.

La lentille 9 peut être avantageusement une lentille sphérique comme dans le module récepteur M_{R} illustré en figures 2, 2A et 3. Elle peut être également une simple fenêtre optique transparente comme dans le module émetteur M_{E} en figure 4.

Comme visible en figure 2 pour le module émetteur M_{E} et en figure 4 pour le module récepteur M_{R} le capot 8 vient protéger mécaniquement le dispositif 9 déjà aligné dans son support 10.

Selon un mode de réalisation avantageux, il est prévu des groupes de mire d'alignement 11, 12, 13 réalisés directement sur la surface supérieure du circuit imprimé 1 qui permettent de manière simple d'obtenir des alignements mécaniques entre chaque composant constitutif de l'empilement d'un module selon l'invention et de ce dernier avec la carte d'application sur laquelle il est destinée à être fixé.

Garantir les alignements mécaniques permet de garantir des alignements optiques nécessaires au bon fonctionnement du système optoélectronique intégrant au moins un module émetteur M_{E} et au moins un module récepteur M_{R} qui convertit en signal numérique un signal optique émis par le module émetteur.

Toutes les mires 11, 12, 13 qui permettent les différents alignements mécaniques sont de préférence constituées d'un quadrillage de carreaux adjacents, deux carreaux adjacents étant d'un contraste différent, en particulier par changement local de couleur du substrat du circuit imprimé 1, comme illustré aux figures 5 à 7.

Les mires 11, 12, 13 permettent comme expliqué par la suite de garantir des alignements mécaniques avec une machine de positionnement de composants usuelle, généralement connue sous la dénomination machine « pick and place ».

Ainsi, tout d'abord les mires 11 permettent un alignement mécanique entre le circuit imprimé 1 du module et le composant optoélectronique 3 par le positionnement de lignes L1 en coïncidence avec les mires 11, comme montré en figure 5.

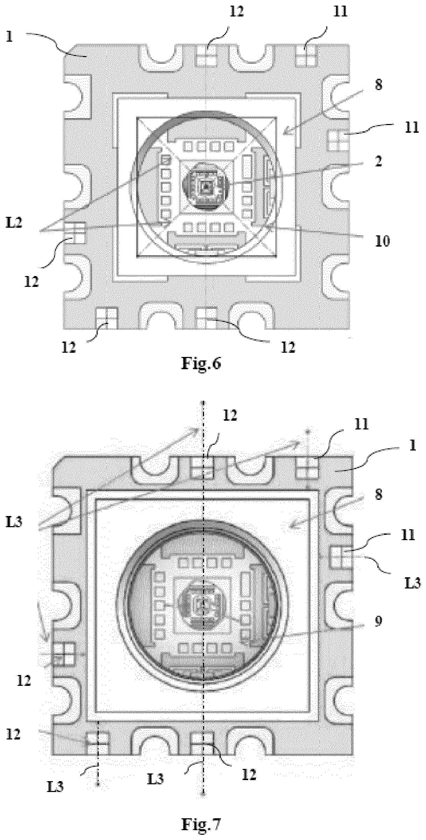

Les mires 12 permettent un alignement mécanique entre le composant optoélectronique 3 et le support 10 de la lentille 9 par le positionnement de lignes L2 en coïncidence avec les mires 12, comme montré en figure 6. L'alignement mécanique permet d'atteindre aisément une tolérance de positionnement du support 10 et donc de la lentille optique 9 par rapport au composant optoélectronique 3 selon les trois axes x, y et z telle qu'aucune opération de réglage du faisceau laser n'est nécessaire une fois le module selon l'invention fixé sur sa carte d'application. L'absence d'alignement dynamique, c'est-à-dire avec des composants sous tension électrique, autorise un assemblage à moindre coût.

Enfin, les mires 13 permettent un alignement mécanique entre le circuit imprimé 1 et la carte d'application sur laquelle le module optoélectronique est mis en place avant d'être fixé, par le positionnement de lignes L3 en coïncidence avec les mires 12, comme montré en figure 6. Un module optoélectronique selon l'invention peut donc être aligné aisément par un client-utilisateur disposant de la carte d'application, de préférence par une technique de composant monté en surface CMS puis fixé notamment soudé par refusion.

Comme cela ressort du mode illustré aux figures 5 à 7, les groupes de mires 11, 12, 13 peuvent avoir des mires en commun.

Les principales étapes de réalisation d'un module optoélectronique M selon l'invention sont donc les suivantes :
- positionnement mécanique du composant électronique de commande 2 par rapport au circuit imprimé 1, puis fixation du composant de commande 2 directement sur la carte;
- alignement mécanique du composant optoélectronique 3 par rapport au circuit imprimé 1 au moyen des mires 11, puis fixation du composant optoélectronique aligné, directement sur le composant de commande 2 fixé ;
- alignement mécanique du support 10 de lentille par rapport au composant optoélectronique au moyen des mires 12, puis fixation du support 10 de lentille aligné, directement sur le circuit imprimé 1.

Une fois le module optoélectronique M réalisé, on peut avantageusement le doter d'un couvercle qui vient coiffer et protéger mécaniquement l'ensemble des composants y compris le dessus de la lentille 9. Ce couvercle peut par exemple venir s'encliqueter sur les bords du capot 8. Ainsi, lors du transport et des manipulations du module M jusqu'à sa mise en place et fixation sur une carte d'application, tous les composants du module sont protégés mécaniquement. Un client-utilisateur n'a plus qu'à ôter ce couvercle, notamment par simple déclipsage manuel ou avec un outil immédiatement avant la mise en place sur la carte d'application.

Un client-utilisateur de la carte d'application a ensuite à réaliser uniquement une étape d'alignement mécanique du module optoélectronique M selon l'invention par rapport à la carte électronique d'application au moyen des mires 13, puis la fixation du module optoélectronique M aligné, directement sur la carte électronique d'application, de préférence par soudure de refusion selon une technique dite de composant monté en surface (CMS).

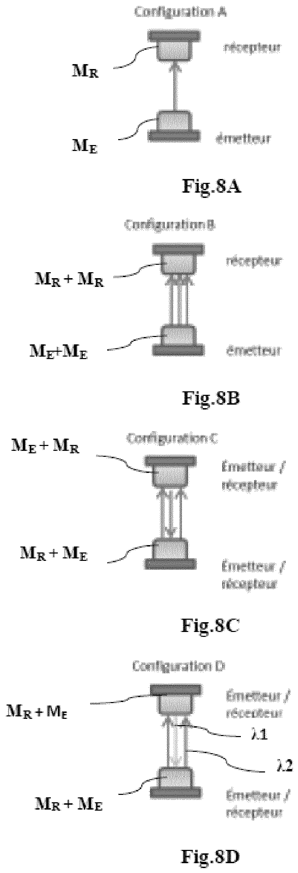

La figure 8A décrit la configuration d'un système d'interconnexion optique avec un module optoélectronique de type émetteur comme celui illustré en figure 2 qui est interconnecté avec un module optoélectronique de type émetteur comme celui illustré en figure 4.

On peut envisager d'associer au moins deux modules optoélectroniques selon l'invention qui viennent d'être décrits dans un même module multivoies. Dans ce cas, les deux ou plusieurs modules optoélectroniques sont fixés sur un même circuit imprimé 1.

En variante, on peut prévoir qu'au sein d'un module multivoies tous les modules optoélectroniques partagent le même dispositif optique 9 et le même support de dispositif optique 10.

En variante, comme montré en figure 8B, tous les modules optoélectroniques d'un même module multivoies peuvent être du même type, émetteur ou récepteur, par exemple des diodes lasers ou des photodiodes. Ainsi comme montré sur cette figure 8B, un module multivoies comprenant un nombre n de modules émetteurs est interconnecté avec un module multivoies comprenant un même nombre n de modules récepteurs.

En variante, les diodes lasers peuvent fonctionner à la même longueur d'onde λ. Dans ce cas, avantageusement, une seule puce appelée barrette comportera les diodes lasers. Selon une autre variante, les diodes laser peuvent fonctionner à des longueurs d'ondes différentes λ1 et λ2 par exemple comme montré en figure 8D.

Dans une autre variante illustrée en figure 8C, un module multivoies peut comporter à la fois au moins une diode laser et une photodiode.

D'autres variantes et améliorations peuvent être prévues sans pour autant sortir du cadre de l'invention.

L'expression « comportant un » doit être comprise comme étant synonyme de « comportant au moins un », sauf si le contraire est spécifié.

## Revendications

1. Module optoélectronique (M), destiné à assurer une conversion d'un signal électrique depuis une carte électronique en un signal optique propagé en espace libre ou vice-versa, comprenant l'empilement suivant:
- une carte électronique (1) destinée à servir d'interface avec une carte électronique d'application ;
- un composant électronique de commande (2) adapté pour réaliser la commande d'un composant optoélectronique, le composant électronique étant fixé directement sur la carte électronique et relié électriquement au circuit électronique;
- un composant optoélectronique (3) adapté pour émettre ou recevoir un signal lumineux par sa surface supérieure, le composant optoélectronique étant fixé directement sur le dessus du composant électronique de commande et relié électriquement au composant électronique;
- un dispositif optique (9) adapté pour transmettre un signal optique ;
- un support (10) de dispositif optique, le support étant fixé, de préférence par collage ou brasage, directement sur la carte électronique de sorte à assurer l'alignement mécanique entre le dispositif optique et le composant optoélectronique.

2. Module optoélectronique selon la revendication 1 constituant un module émetteur (M_{E}), le composant électronique de commande étant un circuit de commande de composants optoélectroniques émettant par la surface.

3. Module optoélectronique selon la revendication 1 constituant un module récepteur (M_{R}), le composant électronique de commande étant un amplificateur à transimpédance, le composant optoélectronique étant une photodiode, notamment une photodiode PIN.

4. Module optoélectronique selon l'une des revendications précédentes, le dispositif optique étant une lentille réfractive ou une lentille diffractive ou une combinaison d'éléments réfractifs et diffractifs.

5. Module optoélectronique selon l'une des revendications précédentes, comprenant un capot (8) fixé directement sur la carte électronique, le capot étant adapté pour protéger mécaniquement les composants et la carte électronique et le cas échéant la lentille et son support vis-à-vis de l'environnement extérieur.

6. Module optoélectronique selon l'une des revendications précédentes, le substrat de la carte électronique comprenant sur sa face supérieure, au moins un premier groupe de repères (11) formant des mires de positionnement du composant optoélectronique relativement à la carte électronique.

7. Module optoélectronique selon l'une des revendications 4 à 6, le substrat de la carte électronique comprenant sur sa face supérieure, au moins un deuxième groupe de repères (12) formant des mires de positionnement du composant optoélectronique relativement au support de lentille.

8. Module optoélectronique selon l'une des revendications précédentes, le substrat de la carte électronique comprenant sur sa face supérieure ou sur sa face inférieure ou sur l'un au moins de faces latérales, au moins un troisième groupe de repères (13) formant des mires de positionnement du module optoélectronique relativement à une carte électronique d'application sur laquelle le module est destiné à être fixé.

9. Module optoélectronique selon l'une des revendications précédentes, le substrat de la carte électronique comprenant un connecteur électrique destiné à être connecté avec un connecteur électrique complémentaire relié à la carte électronique d'application.

10. Module multivoies comprenant au moins deux modules optoélectroniques selon l'une des revendications 4 à 8, avec une carte électronique commune sur laquelle les composants électroniques de commande sont fixés.

11. Module multivoies selon la revendication 10, comprenant un dispositif optique et un support de dispositif optique communs aux modules optoélectroniques.

12. Module multivoies selon la revendication 10 ou 11, les composants électroniques de commande étant tous réalisés dans une même puce usuellement appelée barrette.

13. Système d'interconnexion optique comprenant :
- au moins un module émetteur selon l'une des revendications 2,4 à 10;
- au moins un module récepteur selon l'une des revendications 3 à 10.

14. Procédé de réalisation d'un module optoélectronique selon l'une des revendications 1 à 10, comprenant les étapes suivantes:
- positionnement mécanique du composant électronique de commande par rapport à la carte électronique puis fixation du composant de commande directement sur la carte;
- alignement mécanique du composant optoélectronique par rapport à la carte électronique au moyen du premier groupe de mires, puis fixation du composant optoélectronique aligné, directement sur le composant de commande fixé ;
- alignement mécanique du support de dispositif optique par rapport au composant optoélectronique au moyen du deuxième groupe de mires, puis fixation du support de dispositif optique aligné, directement sur la carte.

15. Procédé de connexion d'un module optoélectronique selon l'une des revendications 1 à 10 sur une carte électronique d'application, comprenant une étape d'alignement mécanique du module optoélectronique par rapport à la carte électronique d'application au moyen du troisième groupe de mires, puis fixation du module optoélectronique aligné, directement sur la carte électronique d'application

## Patentansprüche

1. Optoelektronisches Modul (M), das dazu bestimmt ist, eine Umwandlung eines elektrischen Signals von einer elektronischen Karte in ein optisches Signal, das sich in einem freien Raum ausbreitet, oder umgekehrt vorzunehmen, welches Modul die folgende Kombination aufweist:
- eine elektronische Karte (1), die dazu bestimmt ist, als Schnittstelle mit einer elektronischen Karte für eine Anwendung zu dienen;
- eine elektronische Steuerungsbaugruppe (2), die dazu eingerichtet, eine optoelektronische Baugruppe zu steuern, wobei die elektronische Baugruppe direkt auf der elektronischen Karte befestigt und elektrisch mit der elektronischen Schaltung verbunden ist;
- eine optoelektronische Baugruppe (3), die dazu eingerichtet ist, ein Lichtsignal über seine obere Oberfläche zu senden oder zu empfangen, wobei die optoelektronische Baugruppe direkt auf der Oberseite der elektronischen Steuerungsbaugruppe befestigt und elektrisch mit der elektronischen Baugruppe verbunden ist;
- eine optische Einrichtung (9), die dazu eingerichtet ist, ein optisches Signal zu übertragen;
- einen Träger (10) für die optische Einrichtung, wobei der Träger, vorzugsweise durch Kleben oder Löten, direkt auf der elektronischen Karte befestigt ist, derart, dass die optische Einrichtung und die optoelektronische Baugruppe mechanisch miteinander ausgerichtet werden.

2. Optoelektronisches Modul nach Anspruch 1, das ein Sendemodul (M_{E}) bildet, bei dem die elektronische Steuerungsbaugruppe eine Steuerschaltung für optoelektronische Baugruppen ist, die über die Oberfläche emittieren.

3. Optoelektronisches Modul nach Anspruch 1, das ein Empfangsmodul (M_{R}) bildet, bei dem die elektronische Steuerungsbaugruppe ein Transimpedanzverstärker ist, wobei die elektronische Baugruppe eine Fotodiode ist, insbesondere eine PIN Fotodiode.

4. Optoelektronisches Modul nach einem der vorstehenden Ansprüche, bei dem die optische Einrichtung eine Beugungslinse oder eine Brechungslinse oder eine Kombination aus beugenden und brechenden Elementen ist.

5. Optoelektronisches Modul nach einem der vorstehenden Ansprüche, mit einer Kappe (8), die direkt auf der elektronischen Karte befestigt ist, wobei die Kappe dazu eingerichtet ist, die Baugruppen und die elektronische Karte und gegebenenfalls die Linse und ihren Träger mechanisch gegenüber der äußeren Umgebung zu beschützen.

6. Optoelektronisches Modul nach einem der vorstehenden Ansprüche, bei dem das Substrat der elektronischen Karte auf seiner oberen Oberfläche wenigstens eine erste Gruppe von Markierungen (11) aufweist, die Schablonen zur Positionierung der optoelektronischen Baugruppe relativ zu der elektronischen Karte bilden.

7. Optoelektronisches Modul nach einem der Ansprüche 4 bis 6, bei dem das Substrat der elektronischen Karte auf seiner oberen Oberfläche wenigstens eine zweite Gruppe von Markierungen (12) aufweist, die Schablonen für die Positionierung der optoelektronischen Baugruppe relativ zu dem Träger für die Linse aufweisen.

8. Optoelektronisches Modul nach einem der vorstehenden Ansprüche, bei dem das Substrat der elektronischen Karte auf seiner oberen Oberfläche oder auf seiner Unterseite oder auf wenigstens einer seiner seitlichen Flächen wenigstens eine dritte Gruppe von Markierungen (13) aufweist, die Schablonen zur Positionierung des optoelektronischen Moduls relativ zu einer elektronischen Anwendungs-Karte aufweist, an welcher das Modul befestigt werden soll.

9. Optoelektronisches Modul nach einem der vorstehenden Ansprüche, bei dem das Substrat der elektronischen Karte einen elektrischen Verbinder aufweist, der dazu bestimmt ist, mit einem komplementären elektrischen Verbinder verbunden zu werden, der mit der elektronischen Anwendungs-Karte verbunden ist.

10. Mehrwegmodul mit wenigstens zwei optoelektronischen Modulen nach einem der Ansprüche 4 bis 8, mit einer gemeinsamen elektronischen Karte, auf welcher die elektronischen Steuerungsbaugruppen befestigt sind.

11. Mehrwegmodul nach Anspruch 10, mit einer optischen Einrichtung und einem Träger für die optische Einrichtung, die den optoelektronischen Modulen gemeinsam ist.

12. Mehrwegmodul nach Anspruch 10 oder 11, bei dem die elektronischen Steuerungsbaugruppen alle in einem gemeinsamen Chip gebildet sind, der gewöhnlich als Brücke bezeichnet wird.

13. System zur optischen Verbindung, mit:
- wenigstens einem Sendemodul nach einem der Ansprüche 2, 4 bis 10;
- wenigstens einem Empfangsmodul nach einem der Ansprüche 3 bis 10.

14. Verfahren zur Herstellung eines optoelektronischen Moduls nach einem der Ansprüche 1 bis 10, mit den folgenden Schritten:
- mechanisches Positionieren der elektronischen Steuerungsbaugruppe in Bezug auf die elektronische Karte und anschließende Befestigung der elektronischen Baugruppe direkt auf der Karte;
- mechanisches Ausrichten der optoelektronischen Baugruppe in Bezug auf die elektronische Karte mit Hilfe der ersten Gruppe der Schablonen, und anschließende Befestigung der ausgerichteten optoelektronischen Baugruppe direkt auf der befestigten Steuerungsbaugruppe;
- mechanisches Ausrichten des Trägers für die optische Einrichtung in Bezug auf die optoelektronische Baugruppe mit Hilfe der zweiten Gruppe der Schablonen und anschließende Befestigung des ausgerichteten Trägers für die optische Einrichtung direkt auf der Karte.

15. Verfahren zum Anschluss eines optoelektronischen Moduls nach einem der Ansprüche 1 bis 10 an eine elektronische Karte für eine Anwendung, mit einem Schritt der mechanischen Ausrichtung des optoelektronischen Moduls in Bezug auf die elektronische Karte für die Anwendung mit Hilfe der dritten Gruppe der Schablonen und anschließende Befestigung des ausgerichteten optoelektronischen Moduls direkt auf der elektronischen Karte für die Anwendung.

## Claims

1. An optoelectronic module (M), intended to provide a conversion of an electrical signal from an electronic board into an optical signal propagated in free space or vice versa, including the following stack:
- an electronic board (1), intended to act as an interface with an electronic application board;
- an electronic control component (2) suitable for controlling an optoelectronic component, the electronic component being attached directly onto the electronic board and electrically connected to the electronic circuit;
- an optoelectronic component (3) suitable for transmitting or receiving a light signal via its upper surface, the optoelectronic component being attached directly on the top of the electronic control component and electrically connected to the electronic component;
- an optical device (9) suitable for transmitting an optical signal;
- an optical device support (10), the support being attached, preferably by gluing or brazing, directly onto the electronic board so as to ensure the mechanical alignment between the optical device and the optoelectronic component.

2. The optoelectronic module according to Claim 1 consisting of a transmitter module (M_{E}), the electronic control component being a control circuit for surface-emitting optoelectronic components.

3. The optoelectronic module according to Claim 1 consisting of a receiver module (M_{R}), the electronic control component being a transimpedance amplifier, the optoelectronic component being a photodiode, notably a PIN photodiode.

4. The optoelectronic module according to one of the preceding claims, the optical device being a refractive lens or a diffractive lens or a combination of refractive and diffractive elements.

5. The optoelectronic module according to one of the preceding claims, including a casing (8) attached directly onto the electronic board, the casing being suitable for mechanically protecting the components and the electronic board and where necessary the lens and its support with respect to the external environment.

6. The optoelectronic module according to one of the preceding claims, the substrate of the electronic board including on its upper face, at least a first group of reference marks (11), forming positioning patterns for the optoelectronic component relative to the electronic board.

7. The optoelectronic module according to anyone of Claims 4 to 6, the substrate of the electronic board including on its upper face, at least a second group of reference marks (12), forming positioning patterns for the optoelectronic component relative to the lens support.

8. The optoelectronic module according to one of the preceding claims, the substrate of the electronic board including on its upper face or on its lower face or on at least one of the lateral faces, at least a third group of reference marks (13), forming positioning patterns for the optoelectronic module relative to an electronic application board onto which the module is intended to be attached.

9. The optoelectronic module according to one of the preceding claims, the substrate of the electronic board including an electrical connector intended to be connected with a complementary electrical connector connected to the electronic application board.

10. A multichannel module including at least two optoelectronic modules according to anyone of Claims 4 to 8, with a common electronic board onto which the electronic control components are attached.

11. The multichannel module according to Claim 10, including an optical device and an optical device support common to the optoelectronic modules.

12. The multichannel module according to Claim 10 or Claim 11, the optoelectronic components all being produced in the same chip normally called a bar.

13. An optical interconnection system including:
- at least one transmitter module according to one of Claim 2, 4 to Claim 10,
- at least one receiver module according to Claims 3 to 10.

14. Method of producing an optoelectronic module according to one of the claims 1 to 10, including the following steps:
- mechanical positioning of the electronic control component with respect to the electronic board then attaching the control component directly onto the board;
- mechanical alignment of the optoelectronic component with respect to the electronic board by means of the first group of patterns, then attaching the aligned optoelectronic component, directly onto the attached control component;
- mechanical alignment of the optical device support with respect to the optoelectronic component by means of the second group of patterns, then attaching the aligned optical device support, directly onto the board.

15. Method of connecting an optoelectronic module according to one of the claims 1 to 10 onto an electronic application board, including a step of mechanical alignment of the optoelectronic module with respect to the electronic application board by means of the third group of patterns, then attaching the aligned optoelectronic module, directly onto the electronic application board.
